(19) Europäisches Patentamt
European Patent Office
Office européen des brevets

(11) **EP 3 433 627 B1**

(12) **EUROPÄISCHE PATENTSCHRIFT**

(45) Veröffentlichungstag und Bekanntmachung des Hinweises auf die Patenterteilung:
**01.01.2020 Patentblatt 2020/01**

(21) Anmeldenummer: **17708992.7**

(22) Anmeldetag: **20.02.2017**

(51) Int Cl.:
*G01R 31/36* (2019.01)     *G01R 31/3842* (2019.01)
*B60R 16/033* (2006.01)     *G01R 27/08* (2006.01)
*G01R 31/389* (2019.01)

(86) Internationale Anmeldenummer:
**PCT/EP2017/053780**

(87) Internationale Veröffentlichungsnummer:
**WO 2017/162384 (28.09.2017 Gazette 2017/39)**

(54) **VERFAHREN ZUM BESTIMMEN EINES FEHLERZUSTANDS, BATTERIESENSOR UND FAHRZEUGBORDNETZ**

METHOD FOR DETERMINING AN ERROR STATE, BATTERY SENSOR AND VEHICLE ELECTRICAL SYSTEM

PROCÉDÉ PERMETTANT DE DÉTERMINER UNE DÉFAILLANCE, DISPOSITIF DE COMMANDE, CAPTEUR BATTERIE ET RÉSEAU DE BORD

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.03.2016 DE 102016204944**

(43) Veröffentlichungstag der Anmeldung:
**30.01.2019 Patentblatt 2019/05**

(73) Patentinhaber: **Continental Automotive GmbH 30165 Hannover (DE)**

(72) Erfinder: **GRAF, Hans-Michael 93049 Regensburg (DE)**

(56) Entgegenhaltungen:
**US-B1- 6 331 762**

EP 3 433 627 B1

**Beschreibung**

Die Erfindung betrifft ein Verfahren zum Bestimmen eines Fehlerzustands einer Batterie oder ihrer Anschlusspunkte zu einem Bordnetz. Die Erfindung betrifft des Weiteren einen Batteriesensor, welcher dazu konfiguriert ist, ein solches Verfahren auszuführen. Außerdem betrifft die Erfindung ein Fahrzeugbordnetz mit einem solchen Batteriesensor.

In einem Kraftfahrzeug mit klassischem Bordnetz steht typischerweise lediglich eine Batterie zur Verfügung, welche insbesondere in Form einer bekannten Autobatterie, also eines Akkumulators, ausgeführt sein kann. Diese Batterie versorgt typischerweise alle Verbraucher inklusive des Starters mit Energie, falls ein Generator keine Energie liefert. Im Falle eines laufenden Verbrennungsmotors stehen jedoch typischerweise zwei redundante elektrische Energiequellen zur Verfügung, nämlich die Batterie sowie ein von dem Verbrennungsmotor angetriebener Generator. Fällt eine der Energiequellen aus, so kann die jeweils andere Quelle das Bordnetz weiterhin versorgen.

Aus Gründen der Verbrauchsminimierung wurden in Kraftfahrzeugen in den letzten Jahren automatische Stopp-Start-Systeme eingebaut, welche den Verbrennungsmotor bei sehr geringen Geschwindigkeiten des Kraftfahrzeugs ausschalten. Hierdurch entfällt der Generator im Fall eines ausgeschalteten Verbrennungsmotors als zweite, redundante Stromquelle. Sollte jedoch gleichzeitig die Batterie ausfallen, wäre ein sicherer Neustart des Verbrennungsmotors nicht möglich. Dieser Ausfall kann insbesondere auch die Sicherheit des Fahrzeugs, der Fahrzeuginsassen sowie weiterer Verkehrsteilnehmer gefährden, beispielsweise wenn das Fahrzeug auf einem Bahnübergang zum Stehen gekommen ist.

Um das Risiko eines Batterieausfalls zu minimieren, werden Kraftfahrzeuge mit Stopp-Start-Systemen meistens mit Batteriesensoren, insbesondere intelligenten Batteriesensoren, ausgestattet, welche eine Überwachung der Batterie und damit der Startfähigkeit des Kraftfahrzeugs ermöglichen. Sollte eine schwache Batterie erkannt werden, dann erfolgt keine Deaktivierung des Verbrennungsmotors. Mögliche Ursachen für einen plötzlichen Ausfall der Batterie können beispielsweise ein Bruch der Interzellverbinder (elektrische Verbindung zwischen zwei Zellen der Batterie), ein Abfall der positiven oder der negativen Polklemme von den Batteriepolen (bei unzureichender Anpressung), oder ein Durchschmelzen des Polschafts (zwischen Pol und erster/letzter Zelle) wegen thermischer Überlastung sein.

In der US 6,331,762 B1 ist eine Vorrichtung zur Überwachung einer Batterie gezeigt, bei der der Batteriestrom und die Batteriespannung gemessen werden und aus diesen ein dynamischer Leitwert berechnet wird. Weicht der Leitwert um einen definierten Betrag von einem Nominalwert ab, wird dies als Indikation gewertet, dass die Batterie defekt ist.

Es ist deshalb eine Aufgabe der Erfindung, ein Verfahren vorzusehen, mit welchem ein entsprechender Fehlerzustand erkannt werden kann. Insbesondere kann ein Verfahren vorgesehen werden, welches es ermöglicht, innerhalb eines Batteriesensors zu erkennen, dass die Verbindung zwischen Batteriemassekabel und positiver Polklemme hochohmig wird, während der Generator Strom liefert. Hierbei liegt der Fokus auf einem Batteriesensor, welcher auf der Minusseite einer Batterie verbaut ist und über LIN mit einem anderen Steuergerät verbunden ist. Es sind des Weiteren Aufgaben der Erfindung, einen zugehörigen Batteriesensor sowie ein zugehöriges Bordnetz vorzusehen.

Dies wird erfindungsgemäß durch ein Verfahren nach Anspruch 1, einen Batteriesensor nach Anspruch 14 und ein Fahrzeugbordnetz nach Anspruch 15 erreicht. Vorteilhafte Ausgestaltungen können beispielsweise den jeweiligen Unteransprüchen entnommen werden. Der Inhalt der Ansprüche wird durch ausdrückliche Inbezugnahme zum Inhalt der Beschreibung gemacht.

Die Erfindung betrifft ein Verfahren zum Bestimmen eines Fehlerzustands einer Batterie oder ihrer Anschlusspunkte zu einem Bordnetz, welches folgende Schritte aufweist:

- Messen zumindest einer Spannungsänderung der Batterie,
- Messen zumindest einer Stromänderung der Batterie,
- Berechnen eines differenziellen Leitwerts basierend auf der Stromänderung und der Spannungsänderung und
- Feststellen des Fehlerzustands, wenn der differenzielle Leitwert einen Leitwertschwellenwert unterschreitet.

Der differenzielle Leitwert wird nur dann berechnet, wenn die Spannungsänderung über einem Spanungsänderungsschwellenwert liegt.

Dieses Vorgehen hat sich für typische Situationen als besonders vorteilhaft erwiesen, wie weiter unten näher beschrieben werden wird.

Durch das erfindungsgemäße Verfahren wird insbesondere vermieden, dass bei einem Widerstand, welcher im Fall einer hochohmigen Batterie gegen Unendlich geht, Fehler in der digitalen Verarbeitung, insbesondere aufgrund einer möglichen Division durch null, auftreten. Der Leitwert vermeidet dieses Problem dadurch, dass er sich reziprok zum Widerstand verhält. Da der differenzielle Leitwert nur dann berechnet wird, wenn die Spannungsänderung über einem Spanungsänderungsschwellenwert liegt, werden Divisionen durch null bzw. zu große Werte des Leitwerts, welche Probleme in der digitalen Verarbeitung bereiten könnten, vermieden.

Spannungsänderung und/oder Stromänderung können insbesondere bandpassgefiltert werden.

Insbesondere kann der Fehlerzustand einem Ausfall oder einem hochohmigen Zustand der Batterie oder ihrer Anschlussleitungen entsprechen. Dies ermöglicht die vorteilhafte Erkennung eines solchen Fehlerzustands.

Das Verfahren wird bevorzugt an einem Batteriesensor durchgeführt, welcher mit der Batterie verbunden ist.

Die Verbindung mit der Batterie ist insbesondere der Soll-Zustand, wobei bei Hochohmigkeit die Verbindung eventuell ebenfalls hochohmig oder gar nicht mehr vorhanden ist. Es sei somit verstanden, dass sich der erwähnte Zustand insbesondere auf den Normalzustand, also ohne Fehlerzustand bzw. Hochohmigkeit, bezieht.

Bevorzugt werden die Spannungsänderung und die Stromänderung über einen identischen Zeitraum gemessen. Dies kann insbesondere bedeuten, dass die Spannungsänderung und die Stromänderung über einen jeweils gleich langen Zeitraum gemessen werden. Außerdem kann es bedeuten, dass Endpunkte und/oder Anfangspunkte der jeweiligen Messung zeitlich identisch sind.

Die Spannungsänderung kann insbesondere als Differenz zwischen einem zweiten Spannungswert und einem zeitlich davor gemessenen ersten Spannungswert berechnet werden. Die Stromänderung kann insbesondere als Differenz zwischen einem zweiten Stromwert und einem zeitlich davor gemessenen ersten Stromwert berechnet werden. Der zeitliche Abstand zwischen erstem Spannungswert und zweitem Spannungswert einerseits sowie erstem Stromwert und zweitem Stromwert andererseits kann insbesondere gleich sein. Außerdem kann ein Zeitpunkt, zu welchem der erste Spannungswert gemessen wird, dem Zeitpunkt entsprechen, zu welchem der erste Stromwert gemessen wird. Ebenso kann der Zeitpunkt, zu welchem der zweite Spannungswert gemessen wird, dem Zeitpunkt entsprechen, zu welchem der zweite Stromwert gemessen wird.

Die Stromänderung und/oder die Spannungsänderung können insbesondere mit einer Frequenz zwischen 50 Hz und 20 kHz, bevorzugt zwischen 200 Hz und 8 kHz, besonders bevorzugt 1 kHz, gemessen werden. Derartige Frequenzen haben sich in der Praxis als vorteilhaft erwiesen.

Der differenzielle Leitwert kann insbesondere durch Division der Stromänderung durch die Spannungsänderung berechnet werden. Dies entspricht einer typischen und einfachen Berechnung eines Leitwerts.

Der differenzielle Leitwert kann auch mittels einer Least-Square-Analyse, insbesondere über eine Mehrzahl von Stromänderungen und/oder Spannungsänderungen, berechnet werden. Damit kann ein genauerer Leitwert mit einer gewissen Vergleichmäßigung bzw. Mittelwertbildung berechnet werden.

Ansprechend auf das Feststellen des Fehlerzustands kann vorteilhaft das Abschalten eines Verbrennungsmotors deaktiviert werden. Dies vermeidet ein Liegenbleiben, wenn die Batterie hochohmig ist und der Motor somit nicht mehr gestartet werden könnte.

Der differenzielle Widerstand kann insbesondere basierend auf der Stromänderung und der Spannungsänderung berechnet werden, wenn die Stromänderung über einem Stromänderungsschwellenwert liegt, wobei der Fehlerzustand festgestellt wird, wenn der differenzielle Widerstand einen Widerstandsschwellenwert überschreitet. Somit kann auch ein Widerstand im Rahmen des Verfahrens vorteilhaft zur Erkennung eines Fehlerzustands verwendet werden.

Durch die Verwendung des Stromänderungsschwellenwerts kann wiederum eine Division durch null oder ein ähnliches Problem in der digitalen Verarbeitung vermieden werden.

Gemäß einer Ausführung des Verfahrens kann sowohl ein Widerstandszwischenwert wie auch ein Leitwertzwischenwert berechnet werden, und der differenzielle Widerstand wird dann durch Addition des Widerstandszwischenwerts mit dem Inversen des Leitwertzwischenwerts und Teilen des Ergebnisses durch die Zahl 2 berechnet.

Ebenso kann ein Widerstandszwischenwert wie auch ein Leitwertzwischenwert berechnet werden und der differenzielle Leitwert wird durch Addition des Leitwertzwischenwerts mit dem Inversen des Widerstandszwischenwerts und Teilen des Ergebnisses durch die Zahl 2 berechnet.

Derartige Ausführungsformen können eine größere Präzision bieten.

Die Erfindung betrifft des Weiteren einen Batteriesensor, welcher dazu ausgebildet ist, mit einer Batterie und vorzugsweise auch mit einer Fahrzeugchassis verbunden zu werden, wobei diese Fahrzeugchassis typischerweise die Masse darstellt. Der Batteriesensor ist dazu konfiguriert, ein erfindungsgemäßes Verfahren auszuführen. Hierzu kann der Batteriesensor insbesondere Prozessormittel und Speichermittel aufweisen, wobei in den Speichermitteln Programmcode gespeichert ist, bei dessen Ausführung die Prozessormittel ein erfindungsgemäßes Verfahren ausführen bzw. sich entsprechend verhalten. Hinsichtlich des Verfahrens kann auf alle beschriebenen Ausführungen und Varianten zurückgegriffen werden.

Die Erfindung betrifft des Weiteren ein nichtflüchtiges computerlesbares Speichermedium, auf welchem Programmcode gespeichert ist, bei dessen Ausführung durch einen Prozessor ein erfindungsgemäßes Verfahren ausgeführt wird. Hinsichtlich des Verfahrens kann auf alle beschriebenen Ausführungen und Varianten zurückgegriffen werden.

Die Erfindung betrifft des Weiteren ein Fahrzeugbordnetz mit einer Batterie und einem mit der Batterie verbundenen Batteriesensor gemäß der Erfindung, sowie mit einem Generator, welcher vorzugsweise von einem Verbrennungsmotor angetrieben wird. Die Batterie, der Batteriesensor und der Generator haben dabei eine gemeinsame positive Leitung und vorzugsweise auch eine gemeinsame Masse. Diese Masse kann insbesondere eine Fahrzeugchassis sein.

Mittels des erfindungsgemäßen Fahrzeugbordnetzes können die weiter oben beschriebenen Vorteile eines Verfahrens bzw. eines Batteriesensors für ein Fahrzeugbordnetz vorteilhaft verwendet werden. Hinsichtlich des Batteriesensors bzw. des Verfahrens kann dabei auf alle beschriebenen Ausführungen und Varianten zurückgegriffen werden.

Weitere Merkmale und Vorteile wird der Fachmann dem nachfolgend mit Bezug auf die beigefügte Zeichnung beschriebenen Ausführungsbeispiel entnehmen. Dabei zeigen:

Fig. 1: ein Fahrzeugbordnetz in einem Normalzustand, und

Fig. 2: ein Fahrzeugbordnetz in einem Fehlerzustand.

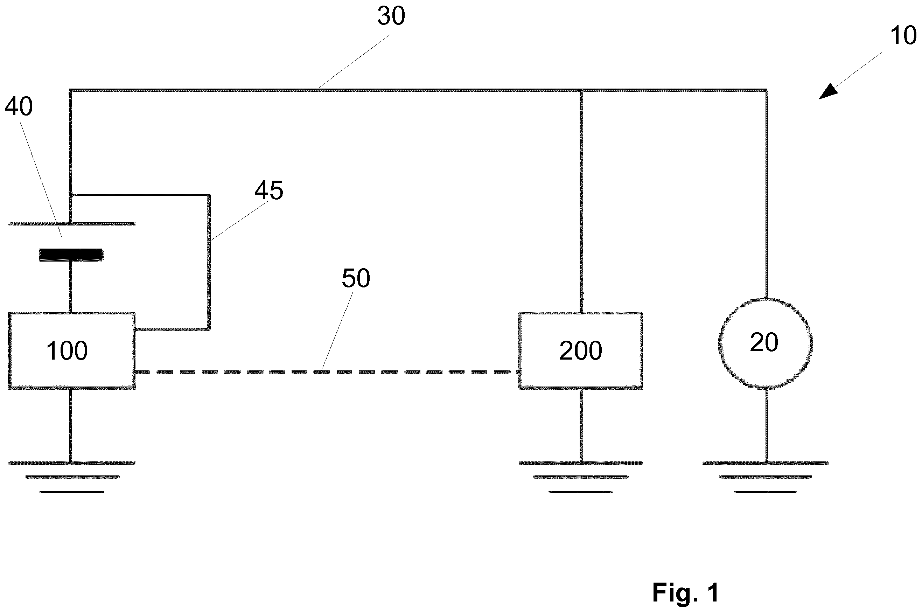

Fig. 1 zeigt ein Fahrzeugbordnetz 10 mit einem Generator 20, einer Batterie 40, einem Batteriesensor 100 und einer Steuerungsvorrichtung 200. Die Batterie 40, die Steuerungsvorrichtung 200 und der Generator 20 sind über eine gemeinsame Plus-Leitung 30 miteinander verschaltet. Der Batteriesensor 100 ist direkt mit dem Minus-Pol der Batterie 40 verbunden und ist außerdem über eine Batterieversorgungsleitung 45 mit dem Plus-Pol der Batterie 40 verbunden, um eine Leistungsversorgung des Batteriesensors 100 sicherzustellen. Des Weiteren ist eine Verbindungsleitung 50 zwischen Batteriesensor 100 und Steuerungsvorrichtung 200 vorgesehen. Damit können der Batteriesensor 100 und die Steuerungsvorrichtung 200 miteinander kommunizieren, wodurch beispielsweise jeweilige gemessene Spannungs-, Strom- oder Temperaturwerte vom Batteriesensor 100 an die Steuerungsvorrichtung 200 übertragen werden können. Außerdem ist eine Steuerung des Batteriesensors 100 durch die Steuerungsvorrichtung 200 möglich.

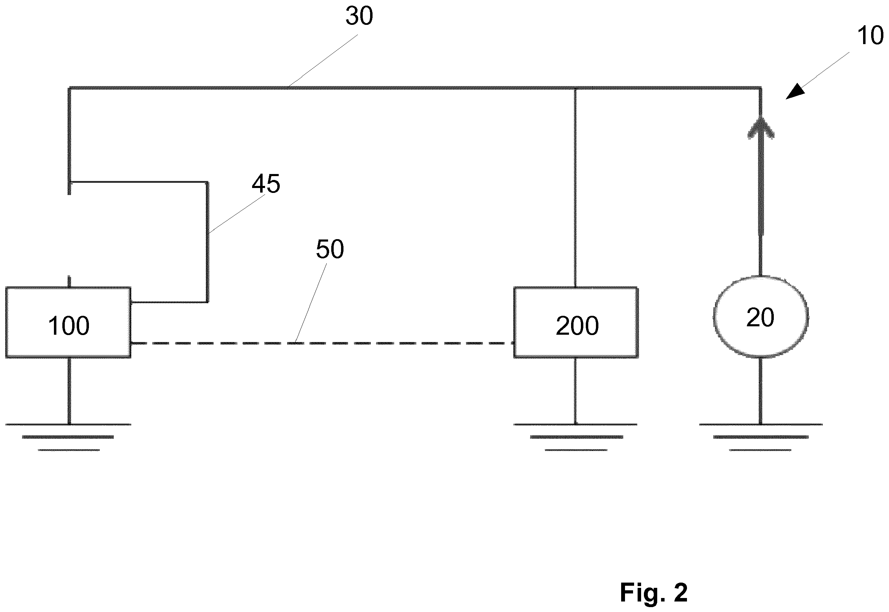

Fig. 2 zeigt einen Zustand des Bordnetzes 10, wenn die Batterie 40 hochohmig ist. Dies ist so dargestellt, dass die Batterie 40 in Fig. 2 nicht mehr vorhanden ist.

Alle Komponenten einschließlich des Batteriesensors 100 hängen dabei weiterhin am Bordnetz 10, sowohl plusseitig wie auch masseseitig. Vom Generator 20 wird zwar weiterhin Strom geliefert, wie durch einen Pfeil in Figur 2 dargestellt ist, es fließt jedoch kein Strom mehr vom Bordnetz 10 durch die Batterie 40 zur Masse. Der Generator 20 wird darüber hinaus weiterhin auf eine Ladespannung von typischerweise 13,8 V bis 14,8 V geregelt. Da die Batterie 40 auch als Filter für die Wechselstromanteile des Generators 20 entfällt, wird die Bordnetzspannung zusätzlich von einem hohen Wechselspannungsanteil überlagert. Würde der Generator 20 keinen Strom mehr liefern, dann würde die Spannung im Bordnetz 10 zusammenbrechen. Anstelle eines Generators wäre natürlich auch jede andere zweite Strom-/Spannungsquelle, inklusive einer zweiten Batterie, denkbar.

Die oben beschriebene Information im Batteriesensor 100, dass der Strom 0 A beträgt und die Spannung bei 11,5 V bis 13 V liegt, ist für sich genommen zwar ein Hinweis auf einen Fehlerzustand, aber typischerweise noch nicht ausreichend, um auf einen Ausfall der Batterie 40 zu schließen. Diese Messwerte können sich beispielsweise auch im Ruhezustand eines Fahrzeugs einstellen.

Bei bekannten Ausführungen tritt häufig das Problem auf, dass bei einer Hochohmigkeit der Batterie der Widerstand so hoch wird, dass dieser nicht mehr im Rahmen der üblichen digitalen Verarbeitung gehandhabt werden kann oder zu sonstigen Problemen führt. Bekannt ist jedoch grundsätzlich die Berechnung des Widerstands der Batterie.

Im Batteriesensor 100 wird hierfür sowohl der von der Batterie 40 zur Masse fließende Strom über einen Messwiderstand, auch als Shunt-Widerstand bezeichnet, als auch die Spannung zwischen Bordnetz 10 bzw. Plus-Leitung 30 und Masse mit einer typischen Frequenz von 200 Hz bis 8 kHz erfasst. Typischerweise erfolgt zusätzlich eine Filterung, insbesondere eine Bandpassfilterung, von Strom und Spannung mit einer Durchlassfrequenz von ca. 50 Hz bis 800 Hz, welche jedoch häufig eine untergeordnete Rolle spielt. Aus Änderungen von Strom und Spannung pro Abtastung, zum Beispiel pro Millisekunde, wird dann ein differenzieller Batteriewiderstand berechnet. Dies kann beispielsweise gemäß folgender Formel erfolgen:

$$R_{diff} = \frac{\Delta_{1ms} U}{\Delta_{1ms} I}$$

Dabei bedeuten

$R_{diff}$:     differenzieller Widerstand,
$\Delta_{1ms}U$:     Spannungsänderung in einer Millisekunde,
$\Delta_{1ms}I$:     Stromänderung in einer Millisekunde.

Fließt jedoch kein Strom von/zu der Batterie 40, ist der Nenner null oder lediglich ein paar Milliampere infolge des Rauschens des Stromkanals. Infolge der numerischen Verarbeitung der Messsignale wird die Berechnung des differenziellen Widerstands für Stromänderungen nahe null unterbunden, da hier sehr große Fehler auftreten bzw. der Wertebereich einen unendlich großen Wert nicht abdeckt.

Üblicherweise wird weiterhin der Widerstand bei Ausführung gemäß dem Stand der Technik nicht jede Millisekunde durch Division von Spannungsänderung und Stromänderung berechnet. Meist werden mehrere Änderungen pro Millisekunde in die Berechnung einbezogen, bevor ein neuer Widerstand berechnet wird. Beispielsweise wird der differenzielle Widerstand durch Least-Square-Analyse berechnet. Hierbei werden virtuell mehrere Paare aus Strom- und Spannungsänderungen in einem Diagramm aufgetragen und eine Ausgleichsgerade hineingefittet. Die Steigung entspricht typischerweise dem Widerstand.

Erfindungsgemäß wird nun anstelle des differenziellen Widerstands ein differenzieller Leitwert berechnet. Dies kann gemäß folgender Formel erfolgen:

$$Leitwert_{diff} = \frac{\Delta_{1ms} I}{\Delta_{1ms} U}$$

Dabei bedeutet:

Leitwert$_{diff}$:    differenzieller Leitwert.

Liegt der Leitwert unterhalb einer Schwelle bzw. eines Leitwertschwellenwerts, dann kann davon ausgegangen werden, dass die Verbindung zwischen Messwiderstand bzw. Shunt-Widerstand und Bordnetz 10 hochohmig ist.

Es wird nun also der Leitwert berechnet und als Kriterium für einen Batterieausfall herangezogen. Dieser Leitwert kann über die Verbindungsleitung 50 der übergeordneten Steuerungsvorrichtung 200 übermittelt werden, welcher dann dafür sorgen kann, dass ein Verbrennungsmotor bzw. Generator im Folgenden nicht mehr abgeschaltet wird. Liegenbleiber während eines Abschaltens des Verbrennungsmotors aufgrund aktivierter Stopp-Start-Funktion werden dadurch weiter minimiert.

Die Berechnung des Leitwerts kann ebenfalls mittels einer Least-Square-Analyse berechnet werden. Hierzu werden im virtuellen Diagramm x-Achse und y-Achse gegeneinander vertauscht. Die Steigung entspricht dann dem Leitwert. Äquivalent zur Berechnung des Widerstands wird die Berechnung des Leitwerts für Spannungsänderungen nahe null unterbunden (Vermeidung einer Division durch null).

Eine weitere positive Ausgestaltung ist die Kombination beider Methoden:

- Berechnung des Widerstands für signifikante Stromänderungen,
- Berechnung des Leitwerts für signifikante Spannungsänderungen.

Für Widerstände im üblichen Bereich, beispielsweise 3 mΩ bis 50 mΩ, könnte der endgültige Widerstand auch aus Mittelung von Widerstand und Leitwert berechnet werden. Dies kann beispielsweise gemäß folgender Formel erfolgen:

$$R = \frac{R_{diff} + \dfrac{1}{Leitwert_{diff}}}{2}$$

Selbiges gilt auch für den Leitwert, insbesondere falls dieser nicht nahe null ist:

$$Leitwert = \frac{Leitwert_{diff} + \dfrac{1}{R_{diff}}}{2}$$

Numerisch könnte darüber hinaus der Widerstand auf den Maximalwert gesetzt werden, beispielsweise hex FFFF, falls der Leitwert Werte unterhalb einer Schwelle annimmt.

Über die Verbindungsleitung 50 bzw. LIN kann dann sowohl dieser Maximalwert des Widerstands (hex FFFF) als auch ein Flag (als Ergebnis des Vergleichs zwischen berechnetem Leitwert und Schwelle) übertragen werden.

Erwähnte Schritte des erfindungsgemäßen Verfahrens können in der angegebenen Reihenfolge ausgeführt werden. Sie können jedoch auch in einer anderen Reihenfolge ausgeführt werden. Das erfindungsgemäße Verfahren kann in einer seiner Ausführungen, beispielsweise mit einer bestimmten Zusammenstellung von Schritten, in der Weise ausgeführt werden dass keine weiteren Schritte ausgeführt werden. Es können jedoch grundsätzlich auch weitere Schritte ausgeführt werden, auch solche welche nicht erwähnt sind.

Die zur Anmeldung gehörigen Ansprüche stellen keinen Verzicht auf die Erzielung weitergehenden Schutzes dar.

Sofern sich im Laufe des Verfahrens herausstellt, dass ein Merkmal oder eine Gruppe von Merkmalen nicht zwingend nötig ist, so wird anmelderseitig bereits jetzt eine Formulierung zumindest eines unabhängigen Anspruchs angestrebt, welcher das Merkmal oder die Gruppe von Merkmalen nicht mehr aufweist. Hierbei kann es sich beispielsweise um eine Unterkombination eines am Anmeldetag vorliegenden Anspruchs oder um eine durch weitere Merkmale eingeschränkte Unterkombination eines am Anmeldetag vorliegenden Anspruchs handeln. Derartige neu zu formulierende Ansprüche oder Merkmalskombinationen sind als von der Offenbarung dieser Anmeldung mit abgedeckt zu verstehen.

Es sei ferner darauf hingewiesen, dass Ausgestaltungen, Merkmale und Varianten der Erfindung, welche in den verschiedenen Ausführungen oder Ausführungsbeispielen beschriebenen und/oder in den Figuren gezeigt sind, beliebig untereinander kombinierbar sind. Einzelne oder mehrere Merkmale sind beliebig gegeneinander austauschbar. Hieraus entstehende Merkmalskombinationen sind als von der Offenbarung dieser Anmeldung mit abgedeckt zu verstehen.

Rückbezüge in abhängigen Ansprüchen sind nicht als ein Verzicht auf die Erzielung eines selbständigen, gegenständlichen Schutzes für die Merkmale der rückbezogenen Unteransprüche zu verstehen. Diese Merkmale können auch beliebig mit anderen Merkmalen kombiniert werden.

Merkmale, die lediglich in der Beschreibung offenbart sind oder Merkmale, welche in der Beschreibung oder in einem Anspruch nur in Verbindung mit anderen Merkmalen offenbart sind, können grundsätzlich von eigenständiger erfindungswesentlicher Bedeutung sein. Sie können deshalb auch einzeln zur Abgrenzung vom Stand der Technik in Ansprüche aufgenommen werden.

**Patentansprüche**

1. Verfahren zum Bestimmen eines Fehlerzustands einer Batterie (40) oder ihrer Anschlusspunkte zu einem Bordnetz (10), welches folgende Schritte aufweist:

   - Messen zumindest einer Spannungsänderung der Batterie (40),
   - Messen zumindest einer Stromänderung der Batterie (40),
   - Berechnen eines differenziellen Leitwerts basierend auf der Stromänderung und der Spannungsänderung, und
   - Feststellen des Fehlerzustands, wenn der differentielle Leitwert einen Leitwertschwellenwert unterschreitet
   - **dadurch gekennzeichnet, dass** der differenzielle Leitwert nur dann berechnet wird, wenn die Spannungsänderung über einem Spannungsänderungsschwellenwert liegt.

2. Verfahren nach Anspruch 1,

   - wobei der Fehlerzustand einem Ausfall oder einem hochohmigen Zustand der Batterie (40) oder ihrer Anschlussleitungen entspricht.

3. Verfahren nach einem der vorhergehenden Ansprüche,

   - welches in einem Batteriesensor (100) durchgeführt wird, welcher mit der Batterie (40) verbunden ist.

4. Verfahren nach einem der vorhergehenden Ansprüche,

   - wobei die Spannungsänderung und die Stromänderung über einen identischen Zeitraum gemessen werden.

5. Verfahren nach einem der vorhergehenden Ansprüche,

   - wobei die Spannungsänderung als Differenz zwischen einem zweiten Spannungswert und einem zeitlich davor gemessenen ersten Spannungswert berechnet wird;

   und/oder
   - wobei die Stromänderung als Differenz zwischen einem zweiten Stromwert und einem zeitlich davor gemessenen ersten Stromwert berechnet wird.

6. Verfahren nach einem der vorhergehenden Ansprüche,

   - wobei die Stromänderung und/oder die Spannungsänderung mit einer Frequenz zwischen 50 Hz und 20 kHz, bevorzugt zwischen 200 Hz und 8 kHz, besonders bevorzugt 1 kHz, gemessen werden.

7. Verfahren nach einem der vorhergehenden Ansprüche,

   - wobei der differenzielle Leitwert durch Division der Stromänderung durch die Spannungsänderung berechnet wird.

8. Verfahren nach einem der vorhergehenden Ansprüche,

   - wobei der differenzielle Leitwert mittels einer least-square-Analyse, insbesondere über eine Mehrzahl von Stromänderungen und/oder Spannungsänderungen, berechnet wird.

9. Verfahren nach einem der vorhergehenden Ansprüche,

   - wobei ansprechend auf das Feststellen des Fehlerzustands das Abschalten eines Verbrennungsmotors deaktiviert wird.

10. Verfahren nach einem der vorhergehenden Ansprüche,

    - wobei ein differentieller Widerstand basierend auf der Stromänderung und der Spannungsänderung berechnet wird, wenn die Stromänderung über einem Stromänderungsschwellenwert liegt,
    - wobei der Fehlerzustand festgestellt wird, wenn der differentielle Widerstand einen Widerstandsschwellenwert überschreitet.

11. Verfahren nach einem der vorhergehenden Ansprüche,

    - wobei sowohl ein Widerstandszwischenwert wie auch ein Leitwertzwischenwert berechnet wird, und
    - wobei der differentielle Widerstand durch Addition des Widerstandszwischenwerts mit dem Inversen des Leitwertzwischenwerts und Teilen des Ergebnisses durch die Zahl 2 berechnet wird.

12. Verfahren nach einem der vorhergehenden Ansprüche,

   - wobei sowohl ein Widerstandszwischenwert wie auch ein Leitwertzwischenwert berechnet wird, und
   - wobei der differentielle Leitwert durch Addition des Leitwertzwischenwerts mit dem Inversen des Widerstandszwischenwerts und Teilen des Ergebnisses durch die Zahl 2 berechnet wird.

13. Batteriesensor (100), welcher dazu ausgebildet ist, mit einer Batterie (40) und vorzugsweise auch mit einer Fahrzeugchassis verbunden zu werden, und welcher dazu konfiguriert ist, ein Verfahren nach einem der vorhergehenden Ansprüche durchzuführen.

14. Fahrzeugbordnetz (10), aufweisend,

   - eine Batterie (40),
   - einen mit der Batterie (40) verbundenen Batteriesensor (100) nach Anspruch 13, und
   - einen Generator (20), welcher vorzugsweise von einem Verbrennungsmotor angetrieben wird,
   - wobei die Batterie (40), der Batteriesensor (100) und der Generator (20) eine gemeinsame positive Leitung (30) haben und vorzugsweise auch eine gemeinsame Masse haben.


**Claims**

1. Method for determining a fault state of a battery (40) or the connection points thereof to an onboard power supply system (10), which method comprises the following steps:

   - measuring at least one voltage change of the battery (40),
   - measuring at least one current change of the battery (40),
   - calculating a differential conductance based on the current change and the voltage change, and
   - ascertaining the fault state when the differential conductance undershoots a conductance threshold value,
   - **characterized in that** the differential conductance is calculated only when the voltage change is above a voltage change threshold value.

2. Method according to Claim 1,

   - wherein the fault state corresponds to a failure or a high-impedance state of the battery (40) or the connection lines thereof.

3. Method according to either of the preceding claims,

   - which method is carried out in a battery sensor (100), which is connected to the battery (40).

4. Method according to one of the preceding claims,

   - wherein the voltage change and the current change are measured over an identical period of time.

5. Method according to one of the preceding claims,

   - wherein the voltage change is calculated as the difference between a second voltage value and a first voltage value measured temporally before said second voltage value; and/or
   - wherein the current change is calculated as the difference between a second current value and a first current value measured temporally before said second current value.

6. Method according to one of the preceding claims,

   - wherein the current change and/or the voltage change are measured at a frequency between 50 Hz and 20 kHz, preferably between 200 Hz and 8 kHz, particularly preferably 1 kHz.

7. Method according to one of the preceding claims,

   - wherein the differential conductance is calculated by division of the current change by the voltage change.

8. Method according to one of the preceding claims,

   - wherein the differential conductance is calculated by means of a least-squares analysis, in particular over a plurality of current changes and/or voltage changes.

9. Method according to one of the preceding claims,

   - wherein the disabling of an internal combustion engine is deactivated in response to the ascertainment of the fault state.

10. Method according to one of the preceding claims,

   - wherein a differential resistance is calculated based on the current change and the voltage change when the current change is above a current change threshold value,
- wherein the fault state is ascertained when the differential resistance exceeds a resistance threshold value.

11. Method according to one of the preceding claims,

- wherein both a resistance intermediate value and a conductance intermediate value are calculated, and
- wherein the differential resistance is calculated by addition of the resistance intermediate value and the inverse of the conductance intermediate value and division of the result by the number 2.

12. Method according to one of the preceding claims,

- wherein both a resistance intermediate value and a conductance intermediate value are calculated, and
- wherein the differential conductance is calculated by addition of the conductance intermediate value and the inverse of the resistance intermediate value and division of the result by the number 2.

13. Battery sensor (100), which is designed to be connected to a battery (40) and preferably also to a vehicle chassis, and which is configured to carry out a method according to one of the preceding claims.

14. Vehicle onboard power supply system (10), having

- a battery (40),
- a battery sensor (100) according to Claim 13 connected to the battery (40), and
- a generator (20), which is preferably driven by an internal combustion engine,
- wherein the battery (40), the battery sensor (100) and the generator (20) have a common positive line (30) and preferably also have a common ground.

## Revendications

1. Procédé de détermination d'un état défectueux d'une batterie (40) ou de ses points de raccordement à un réseau de bord (10), le procédé comprenant les étapes suivantes :

- mesurer au moins une variation de tension de la batterie (40),
- mesurer au moins une variation de courant de la batterie (40),
- calculer une conductance différentielle sur la base de la variation de courant et de la variation de tension, et

- déterminer l'état défectueux si la conductance différentielle tombe au-dessous d'un seuil de conductance,
- **caractérisé en ce que** la conductance différentielle est calculée uniquement si la variation de tension est supérieure à un seuil de variation de tension.

2. Procédé selon la revendication 1,

- l'état défectueux correspondant à une défaillance ou à un état de résistance élevée de la batterie (40) ou de ses conducteurs de raccordement.

3. Procédé selon l'une des revendications précédentes,

- lequel est mis en œuvre dans un capteur de batterie (100) qui est relié à la batterie (40).

4. Procédé selon l'une des revendications précédentes,

- la variation de tension et la variation de courant étant mesurées sur un intervalle de temps identique.

5. Procédé selon l'une des revendications précédentes,

- la variation de tension étant calculée comme différence entre une deuxième valeur de tension et une première valeur de tension mesurée temporellement avant celle-ci ;
et / ou
- la variation de courant étant calculée comme différence entre une deuxième valeur de courant et une première valeur de courant mesurée temporellement avant celle-ci.

6. Procédé selon l'une des revendications précédentes,

- la variation de courant et/ou la variation de tension étant mesurée à une fréquence comprise entre 50 Hz et 20 kHz, de préférence entre 200 Hz et 8 kHz, de manière particulièrement préférée de 1 kHz.

7. Procédé selon l'une des revendications précédentes,

- la conductance différentielle étant calculée par division de la variation de courant par la variation de tension.

8. Procédé selon l'une des revendications précédentes,

- la conductance différentielle étant calculée par analyse par les moindres carrés, en particulier sur une pluralité de variations de courant et/ou de tension.

9. Procédé selon l'une des revendications précédentes,

- l'arrêt d'un moteur à combustion interne étant désactivé en réponse à la détermination de l'état défectueux.

10. Procédé selon l'une des revendications précédentes,

- une résistance différentielle étant calculée sur la base de la variation de courant et de la variation de tension lorsque la variation de courant est supérieure à un seuil de variation de courant,
- l'état défectueux étant déterminé lorsque la résistance différentielle devient supérieure à un seuil de résistance.

11. Procédé selon l'une des revendications précédentes,

- une valeur de résistance intermédiaire et une valeur de conductance intermédiaire étant calculées, et
- la résistance différentielle étant calculée par addition de la valeur de résistance intermédiaire à l'inverse de la valeur de conductance intermédiaire et par division du résultat par le nombre 2.

12. Procédé selon l'une des revendications précédentes,

- une valeur de résistance intermédiaire et une valeur de conductance intermédiaire étant calculées, et
- la valeur de conductance différentielle étant calculée par addition de la valeur de conductance intermédiaire à l'inverse de la valeur de résistance intermédiaire et par division du résultat par le nombre 2.

13. Capteur de batterie (100) qui est conçu pour être relié à une batterie (40) et de préférence également à un châssis de véhicule, et qui est conçu pour mettre en œuvre un procédé selon l'une des revendications précédentes.

14. Réseau de bord de véhicule (10), comprenant

- une batterie (40),
- un capteur de batterie (100) selon la revendication 13 qui est relié à la batterie (40), et
- un générateur (20) qui est de préférence entraîné par un moteur à combustion interne,
- la batterie (40), le capteur de batterie (100) et le générateur (20) ayant un conducteur positif commun (30) et de préférence également une masse commune.

**Fig. 1**

EP 3 433 627 B1

**Fig. 2**

EP 3 433 627 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6331762 B1